# EUROPEAN PATENT SPECIFICATION

(11) **EP 0 957 578 B1**
(45) Date of publication and mention of the grant of the patent: **28.07.2004**
(21) Application number: 98830296.4
(22) Date of filing: 15.05.1998
(51) Int. Cl.: H03H 11/04, H03F 3/30

(54) **Transconductance control circuit, particularly for continous-time circuits**
Transkonduktanzsteuerschaltung insbesondere für zeitkontinuierliche Schaltungen
Circuit de commande d'une transconductance, en particulier pour circuits à temps continu

(43) Date of publication of application: 17.11.1999
(73) Proprietor: STMicroelectronics S.r.l., 20041 Agrate Brianza (Milano) (IT)
(72) Inventor: De Micheli, Marco, 22070 Binago (Prov. of Como) (IT); Portaluri, Salvatore, 27100 Pavia (IT); Bollati, Giacomino, 29015 Castel san Giovanni (Piacenza) (IT); Bruccoleri, Melchiorre, 20017 Rho (Prov. of Milan) (IT)
(74) Representative: Modiano, Guido, Dr.-Ing.

(56) References cited:
- EP-A- 0 561 099
- US-A- 5 572 163
- US-A- 5 650 950
- GEIGER R L ET AL: "ACTIVE FILTER DESIGN USING OPERATIONAL TRANSCONDUCTANCE AMPLIFIERS: A TUTORIAL" IEEE CIRCUITS AND DEVICES MAGAZINE, vol. 1, no. 2, March 1985, pages 20-32, XP002015888

## Description

The present invention relates to a transconductance control circuit, particularly for continuous-time circuits.

It is known that in continuous-time filters provided by means of a transconductor and a capacitor, in which the ratio between transconductance and capacitance determines the cutoff frequency of the filter, it is necessary to have a capacitance which can control the transconductance and thus maintain a constant cutoff frequency for the filter.

In various applications of continuous-time filters it is often desirable to be able to program the cutoff frequency of the filter.

For example, in read channels for hard disk drives it is necessary to equalize the signal arriving from the head of the hard disk. Part of the equalization occurs in the analog domain by means of a filter. The application requires the cutoff frequency to be programmable in a range between 1 and 10 and at a sufficiently high speed. Such cases usually use a transconductor filter as cited above, in which frequency programming occurs by controlling the transconductance of the filter.

It is also important, therefore, to control the transconductance so as to be able to vary the cutoff frequency according to the specific requirements.

A conventional transconductor filter is usually provided by means of a plurality of cascade-connected cells, whose number depends on the order of the filter to be provided.

In particular, inside the filter a so-called master section and a slave section are provided: the master section acts as a reference for the transconductance of the filter and sets a current which is then sent to the subsequent cells that belong to the slave section. US-A-5 650 950 discloses an example of this type of filters.

All the various cells of the filter are of the same type and are similar to the master section of said filter.

The transconductances of the cells of the slave section are the ones that determine the cutoff frequency of the filter.

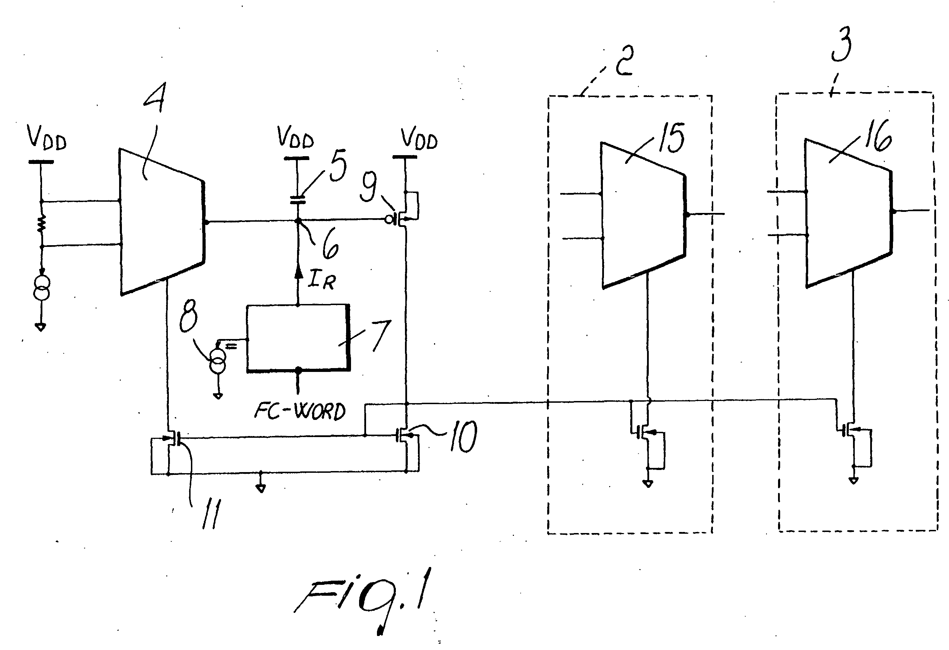

Figure 1 is a circuit diagram of a transconductor filter provided by means of a master section, designated by the reference numeral 1, and by a plurality of cells 2 and 3 (only two cascade-connected cells are shown in this case), forming the slave section of the filter.

The master section further comprises a transconductor 4, the input whereof receives a constant voltage which is generated with absolute precision, so that it does not vary over time, and downstream of the transconductor 4 a capacitor 5 is provided; a DAC 7 is connected to the node designated by the reference numeral 6 in Figure 1, is adapted to generate a reference current I_{R} and receives in input a digital word FC-WORD. The current in output from the transconductor 4 is the same that is set by the DAC 7.

The DAC 7 multiplies a fixed reference current, set by the source 8, by the digital word FC-WORD, in order to obtain in output a reference current I_{R} which is equal to the voltage in input to the transconductor 4 multiplied by the transconductance of said transconductor.

The digital word FC-WORD is used to adjust the transconductance of the filter, i.e., to vary its cutoff frequency. This is in fact done by modifying the digital word that is multiplied by the reference current set by the source 8.

A PMOS transistor 9 is provided in which the gate terminal is connected to the node 6 and the drain terminal is connected to the drain terminal of an NMOS transistor 10, in which in turn the gate terminal is connected to the gate terminal of an additional NMOS transistor 11 which is connected, by means of its source terminal, to the source terminal of the NMOS transistor 10, is common-ground connected, and is connected to the transconductor 4 by means of the drain terminal.

The MOS transistors 9, 10 and 11 constitute a feedback loop which forces the transconductor 4 to have the required transconductance.

The transconductors 15 and 16, which belong to the cells of the filter 2 and 3, are set to the same bias as the master, i.e., to the same current that is mirrored by the NMOS transistor 10.

In this manner, the current set by the master section is sent to all the cascade-connected cells that constitute the filter. Accordingly, the transconductance of the filter is controlled at will, thus allowing to vary the cutoff frequency according to requirements.

The biasing current is varied by changing the digital word FC-WORD entered into the DAC 7.

The above-described structure, however, entails some drawbacks.

First of all, if the transconductance of the filter has to be programmed, it is necessary to be able to quickly vary the transconductances so as to reach a steady-state value and then modify the cutoff frequency of the filter. In the case of the above-described circuit, a time constant is present, set by the capacitor 5, which limits the time during which the transconductance of the filter settles.

Another time constant to be taken into account is the one required to bring the gate terminals of the MOS transistor 10 and of the other transistors of the cells of the filter to the steady state. The higher the order of the filter (i.e., the larger the number of cells of the filter), the greater this time constant.

If one wishes to have a widely adjustable filter, for example adjustable over a range between 1 and 10, i.e., a filter in which the cutoff frequency can be varied by a factor of up to 10, it is necessary to ensure that the settling time of the filter is the shortest possible, but one is limited by the above-described time constants.

It is in fact necessary to wait until the feedback loop enters the steady state before the transconductance of the filter also settles.

The aim of the present invention as defined in the apppended claims is therefore to provide a transconductance control circuit, particularly for continuous-time filters, in which the transconductance settling time, following a request to vary the cutoff frequency of the filter, can be obtained in a considerably shorter time than with the conventional solution.

Within the scope of this aim, an object of the present invention is to provide a transconductance control circuit, particularly for continuous-time filters, in which a considerable percentagewise reduction in the transconductance correction performed by the feedback loop of the circuit is achieved.

Another object of the present invention is to provide a transconductance adjustment circuit, particularly for continuous-time filters, which allows to meet requirements of high speed in programming the transconductance of the filter.

Another object of the present invention is to provide a transconductance control circuit, particularly for continuous-time filters, which is highly reliable, relatively easy to manufacture and at competitive costs.

This aim, these objects and others which will become apparent hereinafter are achieved by a transconductance control circuit, particularly for a continuous-time filter, comprising a transconductor across which a constant voltage is input, said transconductor being connected to a DAC to set a reference current, a feedback loop being provided between the output of said transconductor and its input, characterized in that it further comprises means for mirroring the reference current set by said DAC, said means being adapted to mirror said current both to said feedback loop and to at least one cell of a filter which is cascade-connected.

This aim and these objects are also achieved by a transconductance control method, particularly for continuous-time filters according to claim 1, characterized in that it comprises the steps of:
-- generating a chosen reference current in a master section of a continuous-time filter and sending it to a feedback loop of said master stage, in order to bias the transconductor of said master section, and simultaneously to the cells of a slave section of said filter;
-- feeding back the current in output from said transconductor and adding it algebraically to said reference current, in order to modify the bias of said transconductor in order to have a chosen transconductance, the sum of said reference current and of said output current of the transconductor being again sent to said transconductor and to said cells of the slave section.

Further characteristics and advantages of the invention will become apparent from the description of a preferred embodiment of the circuit according to the invention, illustrated only by way of non-limitative example in the accompanying drawings, wherein:
Figure 1 is a circuit diagram of a conventional transconductor filter; and
Figure 2 is a circuit diagram of the master section of a transconductor filter executed according to the present invention.

Figure 1 illustrates a conventional circuit solution which is not described further herein since it has already been dealt with.

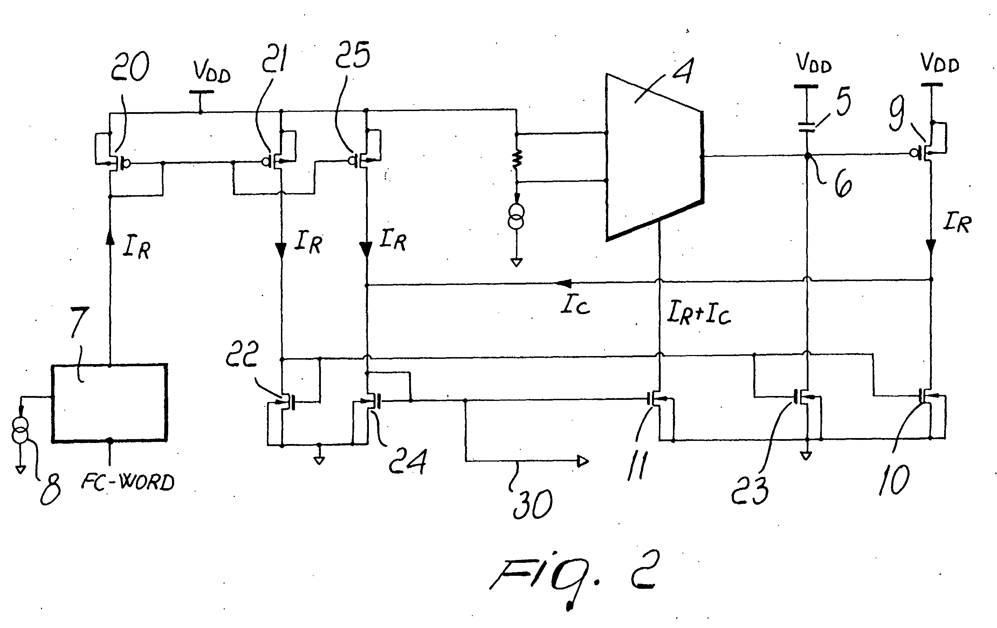

Accordingly, with reference to Figure 2, which illustrates the circuit solution of the master section proposed by the present invention, elements which are similar to those present in Figure 1 are designated by identical reference numerals.

The current in output from the DAC 7, set by means of the reference current generated by the source 8 and the digital word FC-WORD, is mirrored by a diode-connected PMOS transistor 20 which is connected to the DAC by means of the drain terminal and to the supply voltage Vdd by means of its source terminal. The current mirrored by the PMOS transistor 20 passes to the PMOS transistor 21 and is then sent to an NMOS transistor 22 which is diode-connected and mirrors said current to an NMOS transistor 23 which is connected, by means of its drain terminal, to the node 6 whereto the capacitor 5 is connected.

The transistors 9, 10 and 11 constitute, as in the case of Figure 1, the feedback loop of the master section.

The NMOS transistor 22 thus sets the current for the NMOS transistor 23.

The current set in the slave cells of the filter, not shown in Figure 2, is instead supplied by a diode-connected NMOS transistor 24 which is connected, by means of its drain terminal, to the drain terminal of an additional PMOS transistor 25 which is connected, by means of its gate terminal, to the gate terminal of the PMOS transistor 21 and, by means of its source terminal, to the supply voltage Vdd.

The PMOS transistor 25 therefore receives the current set by the mirror constituted by the PMOS transistor 20.

The common point between the drain terminals of the PMOS transistor 25 and the NMOS transistor 24 is connected to the common point between the drain terminals of the PMOS transistor 9 and the NMOS transistor 10.

The NMOS transistor 24 receives a current which is determined by the algebraic sum of the current set by the DAC 7, I_{R}, and of a control current I_{C} which is set by the feedback loop of the master section.

If the current set by the DAC, which is mirrored by the transistor 20 to the transistors 21, 25 and 22, 24 and then to the transistor 23, is the one supplied by the transconductor 4, then the control current I_{C} is nil and the optimum situation occurs in which the transconductor delivers exactly the current required by the DAC 7.

The feedback loop therefore controls the current that is injected into the NMOS transistor 24, which is responsible for the biasing of the cells of the filter that are arranged downstream of the master section.

The arrow designated by the reference numeral 30 in Figure 2 denotes the connection of the master section to the slave section that contains the cells of the filter.

The invention thus biases the transconductor 4 in an open loop by means of a current which is proportional to the current I_{R}. In this manner, the feedback loop has to correct only the bias variations due to temperature, process and power supply variations.

Accordingly, the settling time of the transconductor 4 and therefore of the transconductors of the cells of the slave section is shorter than in the solution shown in Figure 1, since all the transconductors are in any case biased by the current set by the NMOS transistor 24, which receives the current set by the DAC 7. Only after this can the feedback loop complete its task and modify, if necessary, the current set by the NMOS transistor 24, which sends it to the cells of the slave section.

The gate terminal of the NMOS transistor 10 is connected to the gate terminal of the NMOS transistor 23 and to the gate terminal of the NMOS transistor 22, whose gate terminal is connected to the drain terminal.

In practice it has been observed that the circuit according to the present invention fully achieves the intended aim and objects, since it considerably reduces the settling time of the transconductance of the master section and of the slave sections of the filter, at the same time reducing percentagewise the correction performed by the feedback loop of the master section.

The current set by the DAC is in fact sent immediately to a transistor, which fixes the current that is directed to the cells of the slave section; the settling time required by the filter to reach the steady state is therefore reduced.

The transistor that closes the feedback loop on the transconductor 4 feeds to said loop the current which is the sum of the current set by the DAC and of the control current; said sum current is mirrored by the transistor that sets the current for the cells of the slave section.

The circuit thus conceived is susceptible of numerous modifications and variations, all of which are within the scope of the inventive concept as defined in the appended claims; all the details may also be replaced with other technically equivalent elements.

Where technical features mentioned in any claim are followed by reference signs, those reference signs have been included for the sole purpose of increasing the intelligibility of the claims and accordingly such reference signs do not have any limiting effect on the interpretation of each element identified by way of example by such reference signs.

## Claims

1. A transconductance control circuit, particularly for a continuous-time filter, comprising a transconductor (4) across which a constant voltage is input, said transconductor (4) being connected to a DAC (7) to set a reference current (I_{R}), a feedback loop (9, 10, 11, 23) being provided between the output of said transconductor and its input, **characterized in that** it further comprises means (20, 22, 24) for mirroring the reference current set by said DAC, said means being adapted to mirror said current (I_{R}) both to said feedback loop and to at least one cell (2, 3) of a filter which is cascade-connected.

2. A circuit according to claim 1, **characterized in that** said mirroring means comprise a PMOS transistor (20) which is adapted to mirror the current (I_{R}) set by said DAC (7) to a pair of PMOS transistors (21, 25) which have common-connected gate terminals and are in turn connected to a pair of NMOS transistors (22, 24) one of said two NMOS transistors (22) mirroring the reference current set by said DAC to said feedback loop.

3. A circuit according to claim 2, **characterized in that** said feedback loop comprises a first PMOS transistor (9) which is suitable to produce a gain and is connected, by means of its drain terminal, to the drain terminal of an NMOS transistor (10) which is connected, by means of its gate terminal, to the gate terminal and collector terminal of one of the NMOS transistors of said pair of NMOS transistors (22, 24), said feedback loop further comprising an additional pair of NMOS transistors (11, 23) in which the drain terminals are connected respectively to the output node (23, 6) of said transconductor and directly in feedback to said transconductor (4), in order to close said feedback loop.

4. A circuit according to one or more of the preceding claims, **characterized in that** the common drain terminals of the first PMOS transistor (9) and of one of the NMOS transistors (10) that constitute said feedback loop are connected to the drain terminal of the NMOS transistor (24) that is adapted to send the reference current (I_{R}) set by the DAC (7) to said feedback loop and to said at least one cell (2, 3) of the filter.

5. A circuit according to one or more of the preceding claims, **characterized in that** said NMOS transistor (24) suitable to send the current of said DAC to said feedback loop and to said at least one cell of the filter receives in input to the drain terminal said current set by the DAC, summed algebraically with a control current (I_{C}) that arrives from said feedback loop.

6. A circuit according to one or more of the preceding claims, **characterized in that** said DAC (7) receives in input a fixed reference current (8).

7. A circuit according to one or more of the preceding claims, **characterized in that** said PMOS transistor (20) that is connected in output to said DAC (7) is diode-connected.

8. A circuit according to one or more of the preceding claims, **characterized in that** said NMOS transistor (24) suitable to send the current set by said DAC to said feedback loop and to said at least one cell of the filter is diode-connected.

9. A circuit according to one or more of the preceding claims, **characterized in that** said DAC receives in input a digital word (FC-WORD) whose variation allows to modify the output reference current (I_{R}) of said DAC (7).

10. A transconductance control method, particularly for continuous-time filters according to claim 1, **characterized in that** it comprises the steps of:
-- generating a chosen reference current (I_{R}) in a master section (1) of a continuous-time filter and sending it to a feedback loop (9, 10, 11, 29) of said master stage, in order to bias the transconductor (4) of said master section, and simultaneously to the cells (2, 3) of a slave section of said filter;
-- feeding back the current in output from said transconductor (4) and adding it algebraically to said reference current, in order to modify the bias of said transconductor in order to have a chosen transconductance, the sum of said reference current and of said output current of the transconductor being again sent to said transconductor and to said cells of the slave section.

## Patentansprüche

1. Transkonduktanzsteuerschaltung, insbesondere für einen zeitkontinuierlichen Filter, mit einem Transkonduktor (4), über den eine konstante Spannung eingegeben wird, wobei der Transkonduktor (4) an einen DAC (7) angeschlossen ist, um einen Referenzstrom (I_{R}) einzustellen, wobei eine Rückkopplungsschleife (9, 10, 11, 23) zwischen dem Ausgang des Transkonduktors und seinem Eingang vorgesehen ist,
**dadurch gekennzeichnet, dass** sie außerdem Mittel (20, 22, 24) zur Spiegelung des vom DAC eingestellten Referenzstromes aufweist, wobei die Mittel ausgebildet sind, um den Strom (I_{R}) sowohl an der Rückkopplungsschleife als auch an mindestens einer Zelle (2, 3) eines Filters, die in Kaskade geschaltet ist, zu spiegeln.

2. Schaltung nach Anspruch 1,
**dadurch gekennzeichnet, dass** die Spiegelmittel einen PMOS-Transistor (20) aufweisen, welcher ausgebildet ist, um den vom DAC (7) eingestellten Strom (I_{R}) an ein Paar von PMOS-Transistoren (21, 25) zu spiegeln, die gemeinsam geschaltete Gate-Anschlüsse haben und wiederum an ein Paar von NMOS-Transistoren (22, 24) angeschlossen sind, wobei einer der zwei NMOS-Transistoren (22) den vom DAC eingestellten Referenzstrom an die Rückkopplungsschleife spiegelt.

3. Schaltung nach Anspruch 2,
**dadurch gekennzeichnet, dass** die Rückkopplungsschleife einen ersten PMOS-Transistor (9) aufweist, der geeignet ist, um eine Verstärkung zu erzeugen, und mit Hilfe, seines Drain-Anschlusses an den Drain-Anschluss eines NMOS-Transistors (10) angeschlossen ist, der mit Hilfe seines Gate-Anschlusses an den Gate-Anschluss und den Kollektor-Anschluss eines der NMOS-Transistoren des Paares der NMOS-Transistoren (22, 24) angeschlossen ist, wobei die Rückkopplungsschleife außerdem ein zusätzliches Paar von NMOS-Transistoren (11, 23) aufweist, bei denen die Drain-Anschlüsse jeweils am Ausgangsknoten (23, 6) des Transkonduktors und direkt rückgekoppelt an den Transkonduktor ( 4) angeschlossen sind, um die Rückkopplungsschleife zu schließen.

4. Schaltung nach einem oder mehreren der vorangegangenen Ansprüche, **dadurch gekennzeichnet, dass** die gemeinsamen Drain-Anschlüsse des ersten PMOS-Transistors (9) und eines der NMOS-Transistoren (10), die die Rückkopplungsschleife bilden, an den Drain-Anschluss des NMOS-Transistors (24) angeschlossen sind, der ausgebildet ist, um den vom DAC (7) eingestellten Referenzstrom (I_{R}) an die Rückkopplungsschleife und an mindestens eine Zelle (2, 3) des Filters zu übertragen.

5. Schaltung nach einem oder mehreren der vorangegangenen Ansprüche, **dadurch gekennzeichnet, dass** der NMOS-Transistor (24) der geeignet ist, den Strom des DAC an die Rückkopplungsschleife und an mindestens eine Zelle des Filter zu übertragen, am Eingang zum Drain-Anschluss den vom DAC eingestellten Strom empfängt, und zwar algebraisch aufsummiert mit einem Steuerstrom (I_{C}), der von der Rückkopplungsschleife kommt.

6. Schaltung nach einem oder mehreren der vorangegangenen Ansprüche, **dadurch gekennzeichnet, dass** der DAC (7) an seinem Eingang einen festen Referenzstrom (8) empfängt.

7. Schaltung nach einem oder mehreren der vorangegangenen Ansprüche, **dadurch gekennzeichnet, dass** der PMOS-Transistor (20), der an seinem Ausgang an den DAC (7) angeschlossen ist, diodenverschaltet ist.

8. Schaltung nach einem oder mehreren der vorangegangenen Ansprüche, **dadurch gekennzeichnet, dass** der NMOS-Transistor (24), der geeignet ist, um den vom DAC eingestellten Strom an die Rückkopplungsschleife und die mindestens eine Zelle des Filters zu übertragen, diodenverschaltet ist.

9. Schaltung nach einem oder mehreren der vorangegangenen Ansprüche, **dadurch gekennzeichnet, dass** der DAC am Eingang ein digitales Wort (FC-WORD) empfängt, dessen Veränderung es erlaubt, den ausgegebenen Referenzstrom (I_{R}) des DAC (7) zu modifizieren.

10. Transkonduktanzsteuerverfahren, insbesondere für zeitkontinuierliche Filter nach Anspruch 1,
**dadurch gekennzeichnet, dass** es die Schritte aufweist:
- einen gewählten Referenzstrom (I_{R}) in einer Master-Sektion (1) eines zeitkontinuierlichen Filters zu erzeugen und an eine Rückkopplungsschleife (9, 10, 11, 29) der Master-Stufe, um den Transkonduktor (4) der Master-Sektion vorzuspannen, und gleichzeitig an die Zellen (2, 3) einer Slave-Sektion des Filters zu übertragen;
- den Strom am Ausgang vom Transkonduktor (4) zurückzuführen und ihn algebraisch mit dem Referenzstrom zu addieren, um die Vorspannung des Transkonduktors zu modifizieren, um eine gewählte Transkonduktanz zu haben, wobei die Summe des Referenzstromes und des Ausgangsstromes des Transkonduktors wiederum an den Transkonduktor und die Zellen der Slave-Sektion übertragen werden.

## Revendications

1. Circuit de commande de transconductance, en particulier pour un filtre à fonctionnement continu, comprenant un transconducteur (4) aux bornes duquel est appliquée une tension constante, le transconducteur (4) étant connecté à un convertisseur numérique-analogique - DAC - (7) pour fixer un courant de référence (I_{R}), une boucle de réaction (9, 10, 11, 23) étant prévue entre la sortie du transconducteur et son entrée, **caractérisé en ce qu'**il comprend en outre un moyen (20, 22, 24) de recopie du courant de référence établi par le DAC, ledit moyen étant adapté à recopier le courant (I_{R}) vers la boucle de réaction et vers au moins une cellule (2, 3) d'un filtre connecté en cascade.

2. Circuit selon la revendication 1, **caractérisé en ce que** le moyen de recopie comprend un transistor PMOS (20) qui est adapté à recopier le courant (I_{R}) fixé par le DAC (7) vers deux transistors PMOS (21, 25) qui ont des bornes de grille connectées en commun et sont eux-mêmes connectés à deux transistors NMOS (22, 24), l'un des deux transistors NMOS (22) recopiant le courant de référence fixé par le DAC vers la boucle de réaction.

3. Circuit selon la revendication 2, **caractérisé en ce que** la boucle de réaction comprend un premier transistor PMOS (9) adapté à produire un gain et connecté, par sa borne de drain, à la borne de drain d'un transistor NMOS (10) qui est connecté, par sa borne de grille, à la borne de grille et à la borne de collecteur de l'un des transistors NMOS des deux transistors NMOS (22, 24), la boucle de réaction comprenant en outre une paire supplémentaire de transistors NMOS (11, 23) dont les bornes de drain sont respectivement connectées au noeud de sortie (23, 6) du transconducteur et directement en réaction au transconducteur (4), pour fermer la boucle de réaction.

4. Circuit selon une ou plusieurs des revendications précédentes, **caractérisé en ce que** les bornes de drain communes du premier transistor PMOS (9) et de l'un des transistors NMOS (10) qui constitue la boucle de réaction sont connectées à la borne de drain du transistor NMOS (24) qui est adapté à envoyer le courant de référence (I_{R}) fixé par le DAC (7) à la boucle de réaction et à au moins une cellule (23) du filtre.

5. Circuit selon une ou plusieurs des revendications précédentes, **caractérisé en ce que** le transistor NMOS (24), est adapté à envoyer le courant du DAC à la boucle de réaction et à au moins une cellule du filtre, reçoit sur sa borne de drain le courant fixé par le DAC, sommé algébriquement avec un courant de commande (I_{C}) qui arrive de la boucle de réaction.

6. Circuit selon une ou plusieurs des revendications précédentes, **caractérisé en ce que** le DAC (7) reçoit un courant de référence fixe (8).

7. Circuit selon une ou plusieurs des revendications précédentes, **caractérisé en ce que** le transistor PMOS (20) qui est connecté en sortie au DAC (7) est connecté en diode.

8. Circuit selon une ou plusieurs des revendications précédentes, **caractérisé en ce que** le transistor NMOS (24) propre à envoyer le courant fixé par le DAC vers la boucle de réaction et vers au moins une cellule du filtre est connecté en diode.

9. Circuit selon une ou plusieurs des revendications précédentes, **caractérisé en ce que** le DAC reçoit un mot numérique (FC-WORD) dont la variation permet de modifier le courant de référence (I_{R}) de sortie du DAC (7).

10. Procédé de commande de transconductance, en particulier pour filtres à fonctionnement continu selon la revendication 1, **caractérisé en ce qu'**il comprend les étapes suivantes :
- produire un courant de référence choisi (I_{R}) dans une partie maître (1) d'un filtre à fonctionnement continu et l'envoyer à une boucle de réaction (9, 10, 11, 29) de l'étage maître, de façon à polariser le transconducteur (4) de la partie maître, et simultanément vers les cellules (2, 3) d'une partie esclave du filtre ; et
- renvoyer le courant en sortie à partir du transconducteur (4) et l'ajouter algébriquement au courant de référence, pour modifier la polarisation du transconducteur pour obtenir une transconductance choisie, la somme du courant de référence et du courant de sortie du transconducteur étant à nouveau envoyée au transconducteur et aux cellules de la partie esclave.
